# EUROPÄISCHE PATENTANMELDUNG

(11) **EP 4 009 063 A1**
(43) Veröffentlichungstag der Anmeldung: **08.06.2022**
(21) Anmeldenummer: 20210889.0
(22) Anmeldetag: 01.12.2020
(51) Int. Cl.: G01R 31/327

(54) **AUSGABEBAUGRUPPE UND VERFAHREN ZUM BETRIEB**

(71) Anmelder: Siemens Aktiengesellschaft, 80333 München (DE)
(72) Erfinder: Fischer, Peter, 92421 Schwandorf (DE); Dehling, Fabian, 92265 Edelsfeld (DE)

(57) **Zusammenfassung**

Die Erfindung betrifft eine Ausgabebaugruppe (1) mit einem Ausgang (A1) zum Schalten einer Last (L), umfassend ein Schaltmittel (2), welches an den Ausgang (A1) eine Schaltspannung (U_{A}) schaltet und damit ein Laststrom (I_{L}) fließt, wobei
- ein Messmittel (3) ausgestaltet zum Bereitstellen eines Überwachungs-Signalverlaufs (Sᵢ), welcher einen Signalverlauf des Laststromes (I_{L}) aufgrund der Schaltspannung (UA) abbildet,
- ein Analysemittel (4) ausgestaltet den Überwachungs-Signalverlauf (Si) mit einer die Last (L) charakterisierenden Einschaltkennlinie (K1) zumindest punktuell zu vergleichen,
- ein Diagnosemittel (5) ausgestaltet eine Wartungsmeldung (7) zu generieren, wenn der Vergleich eine vorgebbare Abweichung überschreitet.

## Beschreibung

Die Erfindung betrifft eine Ausgabebaugruppe mit einem Ausgang zum Schalten einer Last, umfassend ein Schaltmittel, welches an den Ausgang eine Schaltspannung schaltet und damit ein Laststrom fließt.

Auch betrifft die Erfindung ein Verfahren zum Betrieb einer Ausgabebaugruppe, wobei ein Schaltmittel an einen Ausgang zum Schalten einer Last eine Schaltspannung schaltet und damit ein Laststrom fließt.

Derartige Ausgabebaugruppen sind beispielsweise aus der EP 2 549 843 A1 bekannt. Insbesondere in der industriellen Automatisierungstechnik bzw. der Steuerungstechnik werden Ausgabebaugruppen benötigt, welche beispielsweise Aktoren, Relais oder magnetische Ventile Schalten.

Bei der Ausgabebaugruppe gemäß EP 2 549 843 A1 wird ein Verfahren vorgestellt, bei welchen ein einmalig gesteckter Steckverbinder wieder sicher einer Ausgabebaugruppe zugeordnet werden kann.

Derartig bekannte digitale Ausgabebaugruppen von beispielsweise speicherprogrammierbare Steuerungen zur Ansteuerung von z.B. elektromagnetischen Lasten bzw. induktiven Lasten, ohmschen oder kapazitiven Lasten überwachen lediglich ein Ausgangssignal auf einen eingestellten statischen Wert bezüglich Kurzschluss/Überlast und/oder Drahtbruch. Bei einem Überschreiten eines Grenzwertes sendet die Baugruppe ein Diagnosesignal an ein übergeordnetes System.

Von Nachteil ist es, dass eine z.B. durch Verschleiß oder Verschmutzung bedingte Änderung des Signalverlaufes beim Schalten eines Verbrauchers nicht erkannt wird. Ein möglicher Wartungshinweis kann somit nicht generiert werden, was wiederum zu Ausfällen der Anlage führt und somit hohe Kosten verursacht.

Es ist demnach die Aufgabe der Erfindung die bekannten Ausgabebaugruppen dahingehend zu erweitern, dass ein frühzeitiger Verschleiß von zu schaltenden Lasten erkannt wird.

Die Aufgabe wird dadurch gelöst, dass für die eingangs genannte Ausgabebaugruppe ein Messmittel vorhanden ist, welches ausgestaltet ist, zum Bereitstellen eines Überwachungs-Signalverlaufs, welcher einen Signalverlauf des Laststromes aufgrund der Schaltspannung abbildet, weiterhin aufweisend ein Analysemittel, ausgestaltet den Überwachungs-Signalverlauf mit einer die Last charakterisierenden Einschaltkennlinie zumindest punktuell zu vergleichen, und weiterhin aufweisend ein Diagnosemittel, welches ausgestaltet ist, eine Wartungsmeldung zu generieren, wenn der Vergleich eine vorgebbare Abweichung überschreitet.

Mit Vorteil kann nun ein aktuell aufgenommener Überwachungs-Signalverlauf, beispielsweise eines elektromagnetischen Schalters (Schütz), mit einem Sollverlauf einer Kennlinie, beispielsweise für ein fabrikneues Schütz, verglichen werden. Sollten Abweichungen zwischen dem aktuell aufgenommenen Überwachungs-Signalverlauf und dem Signalverlauf eines neuen Aktors entstehen, kann daraus geschlossen werden, dass die zu schaltende Last gealtert ist oder bald ausgetauscht werden muss.

Eine weitere Verbesserung der Ausgabebaugruppe sieht vor, dass das Analysemittel ausgestaltet ist, eine Höhe einer Versorgungsspannung der Ausgabebaugruppe zu ermitteln und bei einem Vergleich des Überwachungs-Signalverlaufs mit der Einschaltkennlinie die Höhe der Versorgungsspannung derart zu berücksichtigen, dass es bei Schwankungen in der Versorgungsspannung, welche sich ebenfalls auf die Schaltspannung und damit auf den Überwachungs-Signalverlauf auswirken, nicht zu einer fälschlicherweise generierten Wartungsmeldung kommt.

In Abhängigkeit der Höhe der Versorgungsspannung ändern sich auch die Amplitudenwerte des Überwachungs-Signalverlaufs bzw. der ausgegebenen Schaltspannung. Bei einem Vergleich könnten diese Veränderungen wiederum zu einer falschen Information bzw. einer irrtümlichen Wartungsmeldung führen. Bei derzeit bekannten Ausgabebaugruppen kann die Versorgungsspannung in einem Bereich von 20,4 V bis 28,8 V rangieren und trotzdem wird ein sicherer Betrieb gewährleistet. Aber diese große Schwankung der Versorgungsspannung hat auch zur Folge, dass die Schaltspannung für die entsprechend zu schaltenden Last ebenfalls diesen Schwankungen unterliegt. Um zwischen einer Veränderung aufgrund z.B. eines mechanischen Verschleißes oder einer Veränderung der Versorgungsspannung differenzieren zu können, wird die Amplitude der Versorgungsspannung in eine Analyse des Überwachungs-Signalverlaufs mit einbezogen.

Im Hinblick auf eine schnelle und effektive Analyse ist es vom weiteren Vorteil, wenn die Ausgabebaugruppe ein Erfassungsmittel aufweist, welches ausgestaltet ist, bei einer erstmaligen Inbetriebnahme der Last einen Anfangszustand und damit eine Individual-Einschaltkennlinie der Last über einen vorbestimmten Erfassungszeitraum mit einer vorbestimmten Abtastrate zu erfassen, weiterhin ist das Erfassungsmittel dazu ausgestaltet, für den punktuellen Vergleich aus der Individual-Einschaltkennlinie Wertepaare zu ermitteln und abzuspeichern, bei denen eine Steigung im Verlauf der Individual-Einschaltkennlinie das Vorzeichen wechselt oder Null ist, wobei die Wertepaare eine Amplitude und einen Zeitpunkt aufweisen, dass Messmittel ist dann ausgestaltet, ebenfalls in dem vorbestimmten Erfassungszeitraum mit der vorbestimmten Abtastrate den Überwachungs-Signalverlauf bereitzustellen, weiterhin ist das Analysemittel ausgestaltet, für den punktuellen Vergleich aus dem Überwachungs-Signalverlauf aktuelle Wertepaare zu ermitteln bei denen ebenfalls eine Steigung im Verlauf des Überwachungs-Signalverlaufs das Vorzeichen wechselt oder Null ist, weiterhin ist das Analysemittel dazu ausgestaltet, die Wertepaare mit den aktuellen Wertepaaren hinsichtlich einer Verschiebung ihres Zeitpunktes hin zu untersuchen, und bei Überschreiten einer vorgebbaren Abweichung die Wartungsmeldung zu generieren.

Um für einen Vergleich zwischen einer ursprünglichen Einschaltkennlinie und den nachfolgenden aufgenommenen Überwachungs-Signalverläufen einen zu verwendeten Speicherbedarf zu optimieren, werden lediglich die Amplitudenwerte, bezogen auf die Zeitachse, zwischengespeichert, bei denen sich die Steigung des Signalverlaufes signifikant ändert.

Neben dem Vorteil der Speicherplatzersparnis ist dieser punktuelle Vergleich mit Wertepaaren wesentlich schneller und effizienter in einem Algorithmus zu programmieren, so dass die Auswertung der Signalverläufe leistungsstärker ist.

Weiter ist es vom Vorteil, dass mit dem Vergleich der Wertepaare eine Möglichkeit geschaffen wurde, den Einfluss der Höhe der Versorgungsspannung zu berücksichtigen, denn in der Regel wirkt sich die Versorgungsspannung derart aus, dass die Amplitudenwerte des Signalverlaufes in der Regel um einen gewissen Betrag erhöht sind. Das bedeutet, dass die signifikanten Stellen im Signalverlauf, an denen sich die Steigung ändert, also wo Extremwerte im Signalverlauf entstehen, bei einem nicht signifikanten Verschleiß zeitlich an der gleichen Stelle sind. Somit kann der Einfluss der Versorgungsspannung berücksichtigt werden ohne dass es zu einer fälschlicherweise abgesetzten Wartungsmeldung kommt.

Dieser punktuelle Vergleich des Signalverlaufes kann insbesondere bei induktiven Lasten für elektromechanische Stellglieder angewendet werden. Das Analysemittel ist dann ausgestaltet, in Bezug auf eine induktive Last eines elektromechanischen Stellgliedes mit einer Spule und einem Anker in den Überwachungs-Signalverlauf folgende Werte zu ermitteln, ausgehend von einem Startzeitpunkt, bei welchen eine Bestromung der Spule beginnt, wird bei Erreichen eines ersten Zeitpunktes, bei welchem sich der Anker bewegt, ein erster Vergleichswert, bei Erreichen eines zweiten Zeitpunktes, bei welchem der Anker eine Endlage erreicht, wird ein zweiter Vergleichswert ermittelt und bei Erreichen eines dritten Zeitpunktes, bei welchem eine magnetische Sättigung erreicht ist, wird ein dritter Vergleichswert ermittelt. Diese ermittelten Vergleichswerte bilden beispielsweise einen einen Signalverlauf charakterisierenden "Dreipunkte-Verlauf", welche im Hinblick auf das Generieren einer Wartungsmeldung, insbesondere für konstruktive Lasten, ausreichend ist. Für eine andere Art von Last können auch vier oder mehr Punkte verwendet werden.

Weiterhin ist das Analysemittel ausgestaltet, eine Zeitdauer zwischen dem ersten Zeitpunkt und dem zweiten Zeitpunkt zu ermitteln und als ein Verschleißkriterium zu werten und eine Wartungsmeldung zu generieren, wenn die Zeitdauer eine vorgegebene Zeitdauer überschreitet.

Mit Vorteil weist die Ausgabebaugruppe einen Zwischenspeicher auf, der ausgestaltet ist, zum Speichern von Überwachungs-Signalverläufen und Weiterleiten an ein übergeordnetes System. Bezogen auf die Ermittlung der drei Vergleichspunkte, wird der sogenannte Dreipunkt-Verlauf erfasst und ebenfalls zwischengespeichert und später an ein übergeordnetes System weitergeleitet, welches dann aus dem Dreipunkt-Verlauf den charakteristischen Signalverlauf des Überwachungs-Signalverlaufes herauslesen kann. Mit dieser Vorgehensweise kann eine zu speichernde und zu übertragende Datenmenge stark reduziert werden. Sind genug Speicher und Rechenkapazitäten vorhanden können der komplette Signalverlauf und/oder der Dreipunkt-Verlauf übertragen werden.

Insbesondere im Hinblick auf moderne Schütze, welche mit einer PWM-Ansteuerung zur Leistungsreduzierung ausgestaltet sind, ist es von Vorteil, wenn die Baugruppe einen Filter aufweist, welcher zur Berechnung eines geglätteten Signalverlaufs ausgebildet ist, falls der Überwachungs-Signalverlauf als gepulster Signalverlauf vorliegt.

Ebenfalls wird die eingangs genannte Aufgabe durch ein Verfahren zum Betrieb einer Ausgabebaugruppe gelöst, wobei ein Schaltmittel an einen Ausgang zum Schalten einer Last eine Schaltspannung schaltet und damit ein Laststrom fließt, verfahrensgemäß wird ein Überwachungs-Signalverlauf ermittelt, welcher einen Signalverlauf des Laststromes aufgrund der Schaltspannung abbildet, der Überwachungs-Signalverlauf wird derart analysiert, dass er mit einer die Last charakterisierenden Einschaltkennlinie zumindest punktuell verglichen wird, es wird ein Diagnosemittel derart betrieben, eine Wartungsmeldung zu generieren, wenn der Vergleich eine vorgebbare Abweichung überschreitet. Hat man beispielsweise ein Relais in einem Neuzustand und erfasst seinen Einschalt-Kennlinienverlauf, dann ist in einem Vergleich dieser annähernd dem Einschalt-Kennlinienverlauf eines fabrikneuen Relais. Aber sollte ein Überwachungs-Signalverlauf nach beispielsweise 3 Millionen Schaltspielen des Relais aufgenommen werden, so kann man in dem Überwachungs-Signalverlauf Verzögerungen oder veränderte Amplitudenwerte ablesen, welche auf eine Alterung oder einen Verschleiß des Relais hindeuten.

Derzeit bekannte Baugruppen können eine durch Verschleiß oder Verschmutzung bedingte Änderung des Signalverlaufes beim Schalten eines Verbrauchers nicht erkennen. Dementsprechend wird ein möglicher Wartungshinweis nicht generiert, was wiederum zu Ausfällen von industriellen Anlagen führen kann. Dem gegenüber ist nun verfahrensgemäß ein Betrieb einer Ausgabebaugruppe dargestellt, welche dazu führt, frühzeitig eine Wartungsmeldung bei einem drohenden Verschleiß oder einer Verschmutzung auszugeben.

Dazu wird ein Analysemittel betrieben, welches in der Lage ist, eine Höhe einer Versorgungsspannung der Ausgabebaugruppe zu ermitteln und bei einem Vergleich des Überwachungs-Signalverlaufs mit der Einschalt-Kennlinie die Höhe der Versorgungsspannung derart zu berücksichtigen, dass es bei Schwankungen in der Versorgungsspannung, welche sich ebenfalls auf die Schaltspannung und damit auf den Überwachungs-Signalverlauf auswirken, nicht zu einer fälschlicherweise generierten Wartungsmeldung kommt.

Heute bekannte Ausgabebaugruppen, insbesondere für die industrielle Automatisierung, haben einen Versorgungsspannungsbereich von beispielsweise 20,4 bis 28,8 Volt und bei unterschiedlichen Anlagen kann die Versorgungsspannung unterschiedlich ausfallen.

Mittels eines Erfassungsmittels kann bei einer erstmaligen Inbetriebnahme der Last ein Anfangszustand und damit eine Individual-Einschaltkennlinie der Last über einen vorbestimmten Erfassungszeitraum mit einer vorbestimmten Abtastrate erfasst werden, weiterhin werden für den punktuellen Vergleich aus der Individual-Einschaltkennlinie Wertepaare ermittelt und abgespeichert, bei denen eine Steigerung im Verlauf der Individual-Einschaltkennlinie das Vorzeichen wechselt oder Null ist, wobei die Wertepaare eine Amplitude und einen Zeitpunkt aufweisen, mit dem Messmittel wird dann ebenfalls in dem vorbestimmten Erfassungszeitraum mit der vorbestimmten Abtastrate der Überwachungs-Signalverlauf bereitgestellt, weiterhin werden für den punktuellen Vergleich aus dem Überwachungs-Signalverlauf aktuelle Wertepaare ermittelt bei denen ebenfalls eine Steigung im Verlauf des Überwachungs-Signalverlaufs das Vorzeichen wechselt oder Null ist, die Wertepaare aus der Individual-Einschaltkennlinie werden mit dem aktuellen Wertepaaren hinsichtlich einer Verschiebung ihres Zeitpunktes hin verglichen, und bei Überschreiten einer vorgegebenen Abweichung wird die Wartungsmeldung generiert.

Mit dieser Vorgehensweise kann insbesondere ein Einfluss einer Versorgungsspannung leicht ermittelt werden bzw. derart herausgerechnet werden, dass es nicht zu fälschlicherweise abgesetzten Wartungsmeldungen kommt. Denn, bei einem intakten Schütz wird der Amplitudenwert von Extremwerten bei den einen und den anderen Signalverlauf sich nur in der Höhe unterscheiden und der Zeitpunkt der Extremwerte bleibt gleich. Und wenn sich der Extremwert nicht zu anderen Zeitpunkten hin verschoben hat, kann man davon ausgehen, dass kein Verschleiß an den Bauteilen vorliegt, sondern nur die Versorgungsspannung beeinflusst wurde.

Insbesondere in Bezug auf eine induktive Last eines elektromagnetischen Stellgliedes mit einer Spule und einem Anker hat es sich als vorteilhaft herausgestellt in dem Überwachungs-Signalverlauf folgende Werte zu ermitteln, ausgehend von einem Startzeitpunkt, bei welchem eine Bestromung der Spule beginnt, wird bei Erreichen eines ersten Zeitpunktes, bei welchem sich der Anker bewegt, ein erster Vergleichswert, bei Erreichen eines zweiten Zeitpunktes, bei welchem der Anker eine Endlage erreicht, wird ein zweiter Vergleichswert ermittelt und bei Erreichen eines dritten Zeitpunktes, bei welchem eine magnetische Sättigung erreicht ist, wird ein dritter Vergleichswert ermittelt.

Zusätzlich kann eine Zeitdauer zwischen dem ersten Zeitpunkt und dem zweiten Zeitpunkt ermittelt werden und als ein Verschleißkriterium gewertet werden und eine Wartungsmeldung wird generiert, wenn die Zeitdauer eine vorgebbare Zeitdauer überschreitet.

Im Hinblick auf eine vorbeugende Wartung einer Gesamtanlage werden die Überwachungs-Signalverläufe auf der Ausgabebaugruppe zwischengespeichert und an ein übergeordnetes System weitergegeben. Um Speicherplatz zu sparen können auch nur die Vergleichswerte als ein Dreipunkte-Verlauf abgespeichert werden.

Zur Früherkennung werden einem Anlagenbetreiber Wartungsdaten zur Verfügung gestellt.

Die erfindungsgemäße Ausgabebaugruppe mit ihrem Analysemittel zum Analysieren des aufgenommenen Überwachungs-Signalverlaufs kann auch zur Aufzeichnung von Analyse der Versorgungsspannung, zur Aufzeichnung und Analyse der Ausgangsströme von mehreren Kanälen bei einer mehrkanaligen Ausgabebaugruppe verwendet werden. Eine Analyse der Last könnte auch in Bezug auf einem Gleichstrommotor die Drehzahl betreffen. Eine Strommessung würde in die Analyse beispielsweise bei ohmschen Verbrauchern mit einbezogen werden. Es könnten so z.B. korridierte Klemmstellen aufgedeckt werden. Die Analyse beinhaltet die Erkennung von blockierten elektromechanischen Schützen oder Magnetventilen.

Im Hinblick auf eine gepulste Spannung ist im Sinne der Erfindung eine Pulsweitenmodulation-Ansteuerung (PWM) zu verstehen. PWM-Ansteuerungen sind heutzutage weit verbreitet. Viele Steuergeräte haben PWM-Routinen bereits implementiert. Mittels PWM lässt sich auch bei Relaisspulen die Spulenleistung reduzieren und damit die Erwärmung des Relais verhindern.

Im Sinne der Erfindung ist es vorgesehen, Signalverläufe bzw. Signalmuster, welche Schadens-, Verschleiß- oder Fehlzustände bereits im Vorfeld anzeigen, zu analysieren und daraus Wartungsmeldungen zu generieren.

Die Zeichnung zeigt ein Ausführungsbeispiel der Erfindung. Dabei zeigt:
- FIG 1: eine Ausgabebaugruppe zum Schalten einer Last,
- FIG 2: einen typischen Stromverlauf einer induktiven Last,
- FIG 3: einen Kennlinienverlauf mit einem aufgenommenen Überwachungs-Signalverlauf zum Vergleich mit einer Einschaltkennlinie,
- FIG 4: einen Signalverlauf zur Verdeutlichung der Auswirkungen der Schaltspannung auf die Überwachungs-Signalverläufe und
- FIG 5: Signalverläufe für zwei unterschiedliche Versorgungsspannungen.

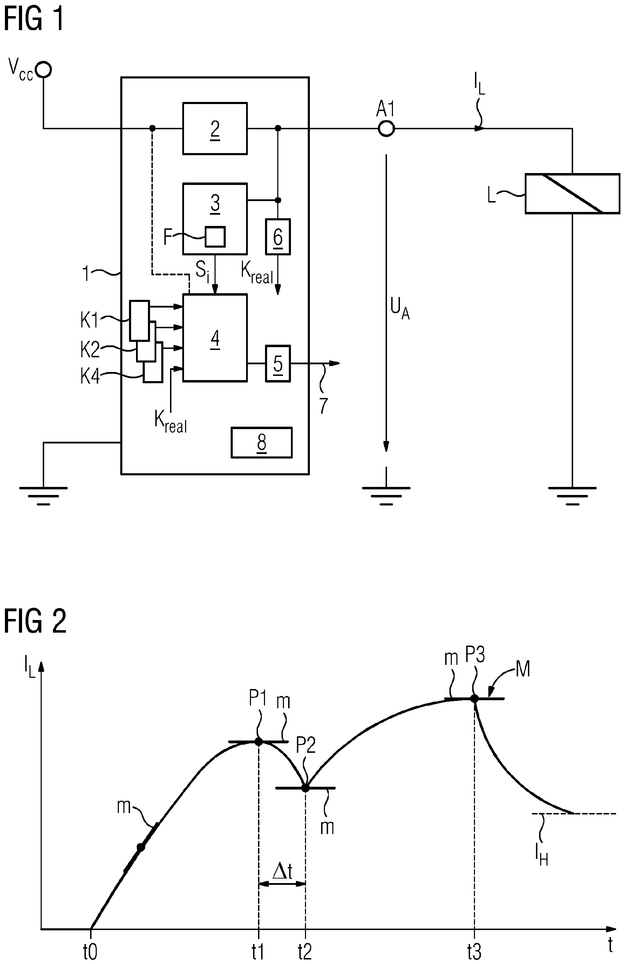

Gemäß FIG 1 ist eine Ausgabebaugruppe mit einem Ausgang A1 zum Schalten einer Last L dargestellt. Die Ausgabebaugruppe umfasst ein Schaltmittel 2, welches an den Ausgang A1 eine Schaltspannung UA schaltet und damit einen Laststrom I_{L} durch die Last L fließt. Derartige Ausgabebaugruppen werden beispielsweise in der industriellen Automatisierungstechnik zum Schalten von Relais oder Magnetventilen genutzt.

Ein Messmittel 3 in der Ausgabebaugruppe 1 ist ausgestaltet, einem Überwachungs-Signalverlauf Si, welcher einem Signalverlauf des Laststromes I_{L} durch die Last L aufgrund der Schaltspannung U_{A} abbildet, aufzunehmen. Diese Aufnahme könnte beispielsweise folgendermaßen ausgeführt sein. Mit dem Aktivieren des Ausgangs A1 erfolgt über einen Stromspiegel eine Abtastung des Signals mittels eines Analog-Digital-Wandlers. Dabei wird der Signalverlauf mit einer vorher definierten Abtastfrequenz über eine vorher definierte Zeit t erfasst und der Ausgabebaugruppe 1 bzw. einem Analysemittel 4 zur weiteren Bearbeitung/Analyse zur Verfügung gestellt.

Das Analysemittel 4 ist ausgestaltet, den Überwachungs-Signalverlauf Si mit einer die Last L charakterisierenden Einschaltkennlinie K1 zumindest punktuell zu vergleichen.

Die Vergleichswerte werden einem Diagnosemittel 5 zugeführt, welches ausgestaltet ist, eine Wartungsmeldung zu generieren, wenn der Vergleich eine vorgebbare Abweichung überschreitet.

Das Analysemittel 4 bekommt als Eingangsgröße den Überwachungs-Signalverlauf Si des jeweils aufgenommenen Stromes der Last L und als weitere Überwachungsgröße unterschiedliche Einschaltkennlinien, nämlich eine erste Einschaltkennlinie K1, eine zweite Einschaltkennlinie K2 und eine dritte Einschaltkennlinie K3, für unterschiedliche Lasten und/oder Versorgungsspannung V_{CC}. Auch ist die Ausgabebaugruppe 1 dazu ausgestaltet, bei einer erstmaligen Inbetriebnahme der Last L einen Anfangszustand und damit eine Individual-Einschaltkennlinie Kᵣₑₐₗ der Last L zu erfassen. Auch diese Individual-Einschaltkennlinie Kᵣₑₐₗ wird als Eingangsgröße dem Analysemittel 4 zur Verfügung gestellt.

Im Hinblick auf ein zu schaltendes Relais mit einer integrierten PWM-Ansteuerung weist die Ausgabebaugruppe 1, vorzugsweise in dem Messmittel 3, einen Filter F auf. Der Filter F dient zur Berechnung eines geglätteten Signalverlaufs, falls der Überwachungs-Signalverlauf Si als gepulster Signalverlauf vorliegen sollte.

Die Ausgabebaugruppe 1 gemäß FIG 1 ist insbesondere dazu ausgestaltet, in Bezug auf eine induktive Last L eines elektromechanischen Stellgliedes mit einer Spule und einem Anker in dem aufgenommenen Überwachungs-Signalverlauf Sᵢ Vergleichswerte zu ermitteln. Für die Erklärung der zu ermittelnden Werte wird auf die FIG 2 verwiesen.

FIG 2 zeigt einen typischen Stromverlauf einer zu schaltenden induktiven Last L. Ausgehend von einem Startzeitpunkt t0, bei welchem eine Bestromung der Spule beginnt, wird bei Erreichen eines ersten Zeitpunktes t1, bei welchem sich der Anker bewegt, ein erster Vergleichswert P1, bei Erreichen eines zweiten Zeitpunktes t2, bei welchem der Anker eine Endlage erreicht, wird ein zweiter Vergleichswert P2 ermittelt und bei Erreichen eines dritten Zeitpunktes t3, bei welchem eine magnetische Sättigung erreicht ist, wird ein dritter Vergleichswert P3 ermittelt. Nach dem Erreichen des dritten Vergleichswertes t3 sinkt der Signalverlauf des Laststromes I_{L} ab und wird in einen Haltestrombereich I_{H} geführt. Das Analysemittel 4 der Ausgabebaugruppe 1 ist für den punktuellen Vergleich ausgestaltet, die Vergleichswerte P1,P2,P3 an den Stellen zu ermitteln, bei denen eine Steigung m im Überwachungs-Signalverlauf Sᵢ das Vorzeichen wechselt oder Null ist. Auch ist das Analysemittel 4 der Ausgabebaugruppe 1 ausgestaltet, eine Zeitdauer Δt zwischen dem ersten Zeitpunkt t1 und dem zweiten Zeitpunkt t2 zu ermitteln und als ein Verschleißkriterium zu werten und eine Wartungsmeldung 7 zu generieren, wenn die Zeitdauer Δt eine vorgebbare Zeitdauer tₙₑᵤ überschreitet.

Mit zunehmender Alterung, beispielsweise eines Schaltrelais oder Schützes, wird sich die Zeit Δt immer weiter vergrößern.

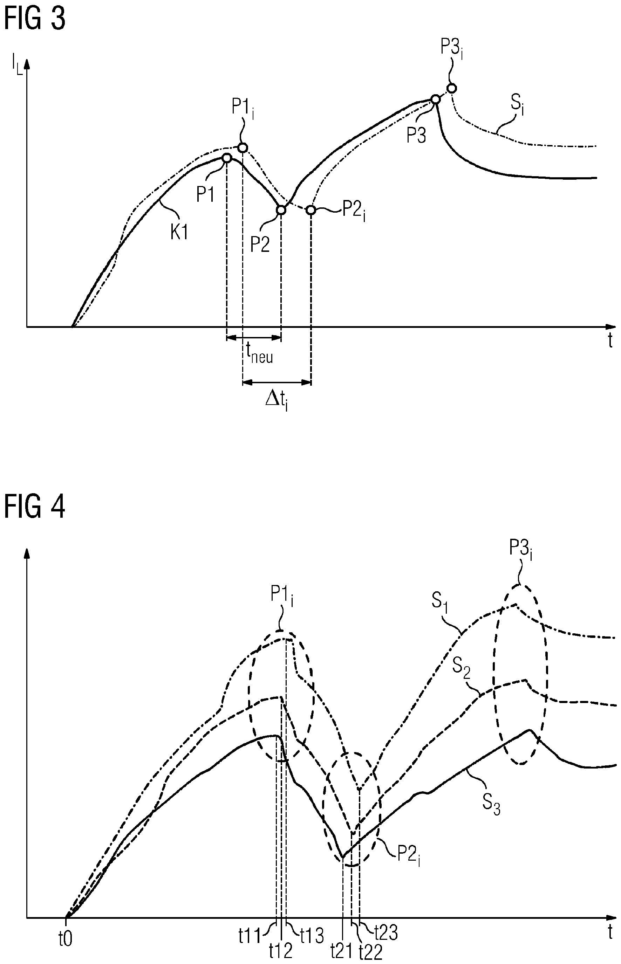

Die FIG 3 zeigt einen Vergleich einer Einschaltkennlinie K1 mit einem aktuell aufgenommenen Überwachungs-Signalverlauf Si. Die Vergleichswerte P1,P2,P3 werden mit den entsprechenden Vergleichswerten P1i,P2i,P3i des entsprechenden Überwachungs-Signalverlauf Si verglichen. Auch wird die Verschiebung oder Vergrößerung der Zeitdauer Δt zwischen dem ersten Zeitpunkt t1 und dem zweiten Zeitpunkt t2 ermittelt und analysiert.

Die FIG 4 zeigt unterschiedliche Überwachungs-Signalverläufe bei unterschiedlichen Versorgungsspannungen V_{CC}. Ein erster Überwachungs-Signalverlauf S₁ ist bei einer ersten Versorgungsspannung V1 aufgenommen worden, ein zweiter Überwachungs-Signalverlauf S₂ ist bei einer zweiten Versorgungsspannung V2 und ein dritter Überwachungs-Signalverlauf S₃ ist bei einer dritten Versorgungsspannung V3 aufgenommen worden. Das Analysemittel 4 der Baugruppe 1 ist nun ausgestaltet, eine Höhe der Versorgungsspannung V_{CC} der Ausgabebaugruppe 1 zu ermitteln und bei einem Vergleich der Überwachungs-Signalverläufe S₁,S₂,S₃ mit einer jeweiligen Einschaltkennlinie K1i, welche die Höhe der entsprechenden Versorgungsspannung repräsentiert, zu vergleichen und derart zu berücksichtigen, dass es bei Schwankungen in der Versorgungsspannung V_{CC}, welche sich ebenfalls auf die Schaltspannung U_{A} und damit auf dem Überwachungs-Signalverlauf Sᵢ auswirken, nicht zu einer fälschlicherweise generierten Wartungsmeldung 7 kommt.

Im Hinblick auf eine speicherplatzschonende Abspeicherung, insbesondere auf der Baugruppe, wird pro Signalverlauf nur ein sogenannter Dreipunkt-Verlauf gemerkt. Die gestrichelten Linien zeigen einen Bereich für die Erfassung von ersten, zweiten und dritten Vergleichswerten P1ᵢ,P2ᵢ und P3ᵢ.

Gemäß FIG 4 ist den Amplituden-Extremwerten der Signalverläufe S1,S2,S3 jeweils ein erster Zeitpunkt t11,t12,t13 und ein zweiter Zeitpunkt t21,t22,t23 zugeordnet. Hieraus ist bereits ersichtlich, dass ein Einfluss der Versorgungsspannung VCC auf die Signalverläufe S1,S2,S3 zwar eine bedeutende Auswirkung auf den Amplitudenwert hat, nicht aber auf den zugehörigen Zeitwert.

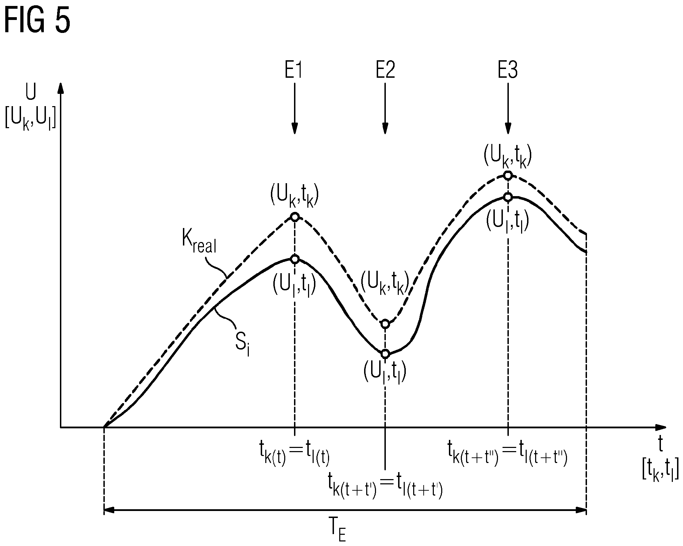

Mit der FIG 5 soll verdeutlicht werden, wie man aus dem Signalverläufen Extremwerte E1,E2,E3 analysieren kann und anhand der zu den Extremwerten E1,E2,E3 zugehörigen Wertepaare U_{K},t_{K} bzw. U_{L},T_{L} kann eine Aussage darüber getroffen werden, ob ein Verschleiß vorliegt oder nicht. Über der Zeit t wird in einen vorbestimmten Erfassungszeitraum T_{E} mit einer vorbestimmten Abtastrate der Signalverlauf erfasst. Für den späteren punktuellen Vergleich der der Wertepaare wird aus der Individual-Einschaltkennlinie Kᵣₑₐₗ jeweils ein dem Extremwert E1,E2,E3 zugehöriges Wertepaar U_{K},T_{K} ermittelt und abgespeichert. Um einen Extremwert E1,E2,E3 im Verlauf der Individual-Einschaltkennlinie Kᵣₑₐₗ herauszufinden, wird die Steigung m des Signalverlaufes untersucht.

Die Wertepaare U_{K},T_{K} weisen bei den Extremwerten E1,E2,E3 jeweils eine Amplituden U_{K} und einen Zeitpunkt t_{K} auf.

Mit dem Messmittel 3 wird dann ebenfalls in dem vorbestimmten Erfassungszeitraum T_{E} mit der vorbestimmten Abtastrate der Überwachungs-Signalverlauf Sᵢ bereitgestellt. Für den späteren punktuellen Vergleich werden aus dem Überwachungs-Signalverlauf Si aktuelle Wertepaare U_{L},T_{L} ermittelt, bei denen ebenfalls eine Steigung m im Laufe des Überwachungs-Signalverlaufs Sᵢ das Vorzeichen wechselt oder Null ist. Die Wertepaare U_{K},t_{K}, aus der Individual-Einschaltkennlinie Kᵣₑₐₗ werden mit den aktuellen Wertepaaren U_{L},T_{L} hinsichtlich einer Verschiebung ihres Zeitpunktes hin verglichen, und bei Überschreiten einer vorgebbaren Abweichung wird die Wartungsmeldung 7 generiert.

Die beiden Signalverläufe gemäß FIG 5 unterscheiden sich nur in ihren maximalen Amplitudenwerten, so wird bei einem ersten Extremwert E1 zu einem Zeitpunkt t_{K (t)} = t_{L(t)} sich nur die jeweilige Amplitude U_{K},U_{L} unterscheiden und zu einem zweiten Extremwert E2 zum Zeitpunkt t_{K} (t+t') = t_{L} (t+t₁') unterscheidet sich ebenfalls nur die Amplitude U_{K},U_{L} und auch zu einem dritten Extremwert E3 zu einen Zeitpunkt t_{K} (t+t") = t_{L} (t+t") unterscheidet sich nur die jeweilige Amplitude U_{K},U_{L}. Da nun die jeweiligen Zeitpunkte zu den jeweiligen Extremwerten E1,E2,E3 in den Wertepaaren U_{K}, t_{K} bzw. U_{L},t_{L} übereinstimmen, kann man deutlich sagen, dass hier keine Alterung oder Verschleiß vorliegt, sondern nur ein Einfluss der Versorgungsspannung VCC die Amplitudenwerte U_{K},U_{L} verschoben hat.

## Patentansprüche

1. Ausgabebaugruppe (1) mit einem Ausgang (A1) zum Schalten einer Last (L), umfassend ein Schaltmittel (2), welches an den Ausgang (A1) eine Schaltspannung (U_{A}) schaltet und damit ein Laststrom (I_{L}) fließt,
**gekennzeichnet durch**,
- ein Messmittel (3) ausgestaltet zum Bereitstellen eines Überwachungs-Signalverlaufs (Sᵢ), welcher einen Signalverlauf des Laststromes (I_{L}) aufgrund der Schaltspannung (UA) abbildet,
- ein Analysemittel (4) ausgestaltet den Überwachungs-Signalverlauf (Si) mit einer die Last (L) charakterisierenden Einschaltkennlinie (K1) zumindest punktuell zu vergleichen,
- ein Diagnosemittel (5) ausgestaltet eine Wartungsmeldung (7) zu generieren, wenn der Vergleich eine vorgebbare Abweichung überschreitet.

2. Ausgabebaugruppe (1) nach Anspruch 1, wobei das Analysemittel (4) ausgestaltet ist, eine Höhe einer Versorgungsspannung (V_{cc}) der Ausgabebaugruppe (1) zu ermitteln und bei einem Vergleich des Überwachungs-Signalverlaufs (Sᵢ) mit der Einschaltkennlinie (K1) die Höhe der Versorgungsspannung (V_{cc}) derart zu berücksichtigen, dass es bei Schwankungen in der Versorgungsspannung (V_{cc}) , welche sich ebenfalls auf die Schaltspannung (U_{A}) und damit auf den Überwachungs-Signalverlauf (Si) auswirken, nicht zu einer fälschlicherweise generierten Wartungsmeldung (7) kommt.

3. Ausgabebaugruppe (1) nach Anspruch 1 oder 2, aufweisend ein Erfassungsmittel (6), welches ausgestaltet ist bei einer erstmaligen Inbetriebnahme der Last(L) einen Anfangszustand und damit eine Individual-Einschaltkennlinie (Kᵣₑₐₗ) der Last (L) über einen vorbestimmten Erfassungszeitraum (T_{E}) mit einer vorbestimmtem Abtastrate zu erfassen, weiterhin ist das Erfassungsmittel (6) dazu ausgestaltet, für den punktuellen Vergleich aus der Individual-Einschaltkennlinie (Kᵣₑₐₗ) Wertepaare (Uₖ,tₖ) zu ermitteln und abzuspeichern, bei denen eine Steigung (m) im Verlauf der Individual-Einschaltkennlinie (Kᵣₑₐₗ) das Vorzeichen wechselt oder Null ist, wobei die Wertepaare (Uₖ,tₖ) eine Amplitude (Uₖ) und ein Zeitpunkt (tₖ) aufweisen,
das Messmittel (3) ist dann ausgestaltet ebenfalls in dem vorbestimmten Erfassungszeitraum (T_{E}) mit der vorbestimmtem Abtastrate den Überwachungs-Signalverlauf (Si) bereitzustellen, weiterhin ist das Analysemittel (4) ausgestaltet, für den punktuellen Vergleich aus dem Überwachungs-Signalverlauf (Si) aktuelle Wertepaare (Uₗ,tₗ) zu ermitteln bei denen ebenfalls eine Steigung (m) im Verlauf des Überwachungs-Signalverlaufs (Sᵢ)) das Vorzeichen wechselt oder Null ist, weiterhin ist das Analysemittel (4) dazu ausgestaltet die Wertepaare (Uₖ,tₖ) mit den aktuellen Wertepaaren (Uₗ,tₗ) hinsichtlich einer Verschiebung ihres Zeitpunktes hin zu untersuchen, und bei Überschreiten einer vorgebbaren Abweichung die Wartungsmeldung (7) zu generieren.

4. Ausgabebaugruppe (1) nach einem der Ansprüche 1 bis 3, wobei das Analysemittel (4) ausgestaltet ist, in Bezug auf eine induktive Last (L) eines elektromechanischen Stellgliedes mit einer Spule und einem Anker in dem Überwachungs-Signalverlauf (Si) folgende Werte zu ermitteln, ausgehend von einem Startzeitpunkt (t0), bei welchen eine Bestromung der Spule beginnt, wird bei Erreichen eines ersten Zeitpunktes (t1), bei welchem sich der Anker bewegt, ein erster Vergleichswert (P1), bei Erreichen eines zweiten Zeitpunktes (t2), bei welchem der Anker eine Endlage erreicht, wird ein zweiter Vergleichswert (P2) ermittelt und bei Erreichen eines dritten Zeitpunktes (t3), bei welchem eine magnetische Sättigung erreicht ist, wird ein dritter Vergleichswert (P3) ermittelt.

5. Ausgabebaugruppe (1) nach Anspruch 4, wobei das Analysemittel (4) ausgestaltet ist, eine Zeitdauer (Δt) zwischen dem ersten Zeitpunkt (t1) und dem zweiten Zeitpunkt (t2) zu ermitteln und als ein Verschleißkriterium zu werten und eine Wartungsmeldung (7) zu generieren, wenn die Zeitdauer (Δt) eine vorgebbare Zeitdauer (tₙₑᵤ) überschreitet.

6. Ausgabebaugruppe (1) nach einem der Ansprüche 1 bis 5, aufweisend einen Zwischenspeicher (8) ausgestaltet zum Speichern von Überwachungs-Signalverläufen (Si) und Weiterleiten an ein übergeordnetes System.

7. Ausgabebaugruppe (1) nach einem der Ansprüche 1 bis 6, mit einem Filter (F) zur Berechnung eines geglätteten Signalverlauf, falls der Überwachungs-Signalverlaufs (Si) als gepulster Signalverlauf vorliegt.

8. Verfahren zum Betrieb einer Ausgabebaugruppe (1), wobei ein Schaltmittel (2) an einem Ausgang (A1) zum Schalten einer Last (L) eine Schaltspannung (UA) schaltet und damit ein Laststrom (I_{L}) fließt,
**dadurch gekennzeichnet, dass** ein Überwachungs-Signalverlauf (Si) ermittelt wird, welcher einen Signalverlauf des Laststromes (I_{L}) aufgrund der Schaltspannung (UA) abbildet,
- der Überwachungs-Signalverlauf (Si) derart analysiert wird, dass er mit einer die Last (L) charakterisierenden Einschaltkennlinie (K1) zumindest punktuell verglichen wird,
- ein Diagnosemittel (5) betrieben wird, eine Wartungsmeldung (7) zu generieren, wenn der Vergleich eine vorgebbare Abweichung überschreitet.

9. Verfahren nach Anspruch 8, wobei das Analysemittel (4) betrieben wird, eine Höhe einer Versorgungsspannung (V_{cc}) der Ausgabebaugruppe (1) zu ermitteln und bei einem Vergleich des Überwachungs-Signalverlaufs (Si) mit der Einschaltkennlinie (K1) die Höhe der Versorgungsspannung (V_{cc}) derart zu berücksichtigen, dass es bei Schwankungen in der Versorgungsspannung (V_{cc}) , welche sich ebenfalls auf die Schaltspannung (UA) und damit auf den Überwachungs-Signalverlauf (Si) auswirken, nicht zu einer fälschlicherweise generierten Wartungsmeldung (7) kommt.

10. Verfahren nach Anspruch 8 oder 9, wobei mittels eines Erfassungsmittels (6) bei einer erstmaligen Inbetriebnahme der Last(L) ein Anfangszustand und damit eine Individual-Einschaltkennlinie (Kᵣₑₐₗ) der Last (L) über einen vorbestimmten Erfassungszeitraum (T_{E}) mit einer vorbestimmtem Abtastrate erfasst wird, weiterhin werden für den punktuellen Vergleich aus der Individual-Einschaltkennlinie (Kᵣₑₐₗ) Wertepaare (Uₖ,tₖ) ermittelt und abgespeichert, bei denen eine Steigung (m) im Verlauf der Individual-Einschaltkennlinie (Kᵣₑₐₗ) das Vorzeichen wechselt oder Null ist, wobei die Wertepaare (Uₖ,tₖ) eine Amplitude (Uₖ) und einen Zeitpunkt (tₖ) aufweisen, mit dem Messmittel (3) wird dann ebenfalls in dem vorbestimmten Erfassungszeitraum (T_{E}) mit der vorbestimmten Abtastrate der Überwachungs-Signalverlaufs (Sᵢ) bereitgestellt, weiterhin werden für den punktuellen Vergleich aus dem Überwachungs-Signalverlauf (Sᵢ) aktuelle Wertepaare (Uₗ,tₗ) ermittelt bei denen ebenfalls eine Steigung (m) im Verlauf des Überwachungs-Signalverlaufs (Sᵢ) das Vorzeichen wechselt oder Null ist, die Wertepaare (Uₖ,tₖ) aus der Individual-Einschaltkennlinie (Kᵣₑₐₗ) werden mit den aktuellen Wertepaaren (Uₗ,tₗ) hinsichtlich einer Verschiebung ihres Zeitpunktes hin verglichen, und bei Überschreiten einer vorgebbaren Abweichung wird die Wartungsmeldung (7) generiert.

11. Verfahren nach einem der Ansprüche 8 bis 10, wobei bei einer induktiven Last(L) eines elektromechanischen Stellgliedes mit einer Spule und einem Anker in dem Überwachungs-Signalverlauf (Sᵢ) folgende Werte ermittelt werden, ausgehend von einem Startzeitpunkt (t0), bei welchem eine Bestromung der Spule beginnt, wird bei Erreichen eines ersten Zeitpunktes (t1), bei welchem sich der Anker bewegt, ein erster Vergleichswert (P1), bei Erreichen eines zweiten Zeitpunktes (t2), bei welchem der Anker eine Endlage erreicht, wird ein zweiter Vergleichswert (P2) ermittelt und bei Erreichen eines dritten Zeitpunktes (t3), bei welchem eine magnetische Sättigung erreicht ist, wird ein dritter Vergleichswert (P3) ermittelt.

12. Verfahren nach Anspruch 11, wobei eine Zeitdauer (Δt) zwischen dem ersten Zeitpunkt (t1) und dem zweiten Zeitpunkt (t2) ermittelt wird und als ein Verschleißkriterium gewertet wird und eine Wartungsmeldung (7) generiert wird, wenn die Zeitdauer (Δt) eine vorgebbare Zeitdauer (tₙₑᵤ) überschreitet.

13. Verfahren nach einem der Ansprüche 9 bis 12, wobei die Überwachungs-Signalverläufe (Sᵢ) auf der Ausgabebaugruppe (1) zwischengespeichert werden und an ein übergeordnetes System weitergegeben werden.
